Europäisches Patentamt

European Patent Office

Office européen des brevets

(11) Publication number: **0 485 809 A1**

## EUROPEAN PATENT APPLICATION

(21) Application number: **91118575.9**

(22) Date of filing: **30.10.91**

(51) Int. Cl.⁵: **G03B 27/32**, G03F 7/00

(30) Priority: **01.11.90 JP 296010/90**
**19.02.91 JP 24930/91**
**19.02.91 JP 24932/91**
**11.03.91 JP 44705/91**
**11.03.91 JP 44706/91**
**28.08.91 JP 217157/91**

(43) Date of publication of application:
**20.05.92 Bulletin 92/21**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**
Applicant: **SEIKO INSTRUMENTS CO., LTD.**
**31-1, Kameido 6-chome, Koto-ku**
**Tokyo(JP)**

(72) Inventor: **Kobayashi, Atsushi**
**c/o Seiko Epson Corporation, 3-5, Owa**
**3-chome**
**Suwa-shi, Nagano-ken(JP)**
Inventor: **Abe, Nobumasa**
**c/o Seiko Epson Corporation, 3-5, Owa**
**3-chome**
**Suwa-shi, Nagano-ken(JP)**
Inventor: **Suzuki, Takashi**
**c/o Seiko Epson Corporation, 3-5, Owa**
**3-chome**
**Suwa-shi, Nagano-ken(JP)**

(74) Representative: **Blumbach Weser Bergen**
**Kramer Zwirner Hoffmann Patentanwälte**
**Radeckestrasse 43**
**W-8000 München 60(DE)**

(54) Image forming device and method for transporting a photosensitive member in such device.

(57) Disclosed are an image forming device and a method for transporting a photosensitive member in the device in which a film type photosensitive member (F) is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8). In order to prevent the formation of wrinkles in the photosensitive member on the transport path a tensioning means for applying a tension to the photosensitive member being transported is disposed in the transport path (6) upstream from the heat developing section (7) or in the supply section (5).

FIG. 1

The present invention relates to copiers, printers, plotters, facsimile machines and other image forming devices that form images by means of a photosensitive transfer type heat developing member. The invention further relates to a method for transporting the photosensitive member.

An image forming device of this type is disclosed in JP-A-62-147461. This prior art device is a color copier comprising a photosensitive member supply section, an exposure section, a heat developing section, a pressure transfer section and a photosensitive member disposal section which are provided along a transport path. The photosensitive member supply section houses a film type photosensitive member rolled up on a core (roll), and it is configured such that it is capable of cutting the photosensitive member to the prescribed length and then supplying it to the exposure section. The exposure section receives light reflected by an original and exposes the photosensitive surface of the photosensitive member to form a latent image corresponding to the original. The heat developing section heat develops the latent image formed on the photosensitive member by heating the photosensitive member to 80° to 200°C for approximately 30 s. The pressure transfer section mates the photosensitive member with a transfer member made from paper, etc., transfers the image on the developed photosensitive member to the transfer member using pressure, and then separates the photosensitive member and the transfer member. In the photosensitive member disposal section, the photosensitive member from which the image has been transferred is successively ejected and stacked.

The photosensitive member employs a plastic film as a base material, on the surface of which are applied microcapsules charged with a photosensitive substance and a pigment. Using this photosensitive member, a photoreaction is initiated in the photosensitive substance in the exposure section (latent image forming), and this change of state is used to effect the pigment by means of heating in the heat developing section and causing it to become selectively hardened. In the pressure transfer section, the microcapsules are crushed, and the pigment that has not been hardened is transferred to the paper, whereby the output image is formed.

The prior art device is not practical because the photosensitive member has to be cut and the developing time is long, thus making the structure and control of the transport system complicated and copy times long. To solve these problems, the photosensitive member could be rolled up so that it can be used continuously without cutting and the developing time could be shortened. However, the following problems could be expected to occur if this were implemented.

When the photosensitive member is heated to a high temperature during developing, wrinkles occur in the continuous sheet-like photosensitive member, thus degrading the quality of the output image. That is, the high heating of the photosensitive member causes thermal stretching or thermal shrinkage. In this case, the lengthwise change in dimension of the photosensitive member is absorbed by changes in the transport speed of the photosensitive member, but the dimensional change in the widthwise direction is not absorbed, and so longitudinal wrinkles appear. The states of stretching or shrinkage before heating, during heating and during cooling after heating are different, thus causing three different states in the photosensitive member during the short period the photosensitive member is in the vicinity of the heat developing section. Moreover, since residual distortion from the film production process remains in the film type photosensitive member, wrinkles in the photosensitive member are not eliminated even after being sufficiently cooled, and in some cases shrinkage may proceed even further, in which condition pressure transfer is performed. These wrinkles can cause uneven developing in the heat developing section or transfer wrinkles in the pressure transfer section, either one of which will degrade the quality or the output image.

If these wrinkles that occur in the heat developing section are extremely small, however, their effect can be avoided by adjusting the developing time or transfer pressure, but if these small wrinkles are be allowed to affect the exposure section due to rewinding, etc., they may cause the photosensitive member to lift, resulting in uneven exposure.

Various experiments have been conducted on the occurrence of wrinkles in the photosensitive member in which a polyethylene terephthalate film was used as the base material of the photosensitive member instead of a plastic film. In a first experiment, tension applied to the photosensitive member was increased in steps, and the occurrence of wrinkles in response to the tension was observed and at the same time the amount of thermal shrinkage of the photosensitive member was investigated. In this case, the photosensitive member was 215 mm wide, the heating temperature (heat developing temperature) of the heat developing section was kept constant at 150°C, and the transport speed of the photosensitive member was 10 mm/s. In a second experiment, the occurrence of wrinkles was observed while the heat developing temperature and pressure transfer temperature were appropriately changed and the transport speed of the photosensitive member was varied accordingly.

The results of the first experiment are shown in TABLE 1 and those of the second experiment in TABLE 2.

EP 0 485 809 A1

TABLE 1

| Film tension $10^{-2}$N (gf) | Thermal shrinkage of photosensitive member | | Uneven exposure due to wrinkles caused by thermal shrinkage |
|---|---|---|---|
| | Lengthwise direction | Widthwise direction | |
| 0 | 1.2% | 0.7% | Unsuitable |
| 200 | 1.1 | 0.6 | Unsuitable |
| 400 | 0.8 | 0.5 | Suitable |
| 600 | 0.5 | 0.5 | Good |
| 800 | 0.5 | 0.5 | Good |

TABLE 2

| Transfer wrinkles due to time difference between heat developing and pressure transfer | | | | | | |
|---|---|---|---|---|---|---|
| Heat developing temperature | Pressure transfer temperature | 1s | 2s | 5s | 10s | 20s |
| 155°C | 30°C | None | None | None | None | Slight |
| 155°C | 50°C | None | None | None | None | Present |
| 155°C | 70°C | None | None | None | Slight | Present |
| 155°C | 90°C | None | None | None | Slight | Present |
| 155°C | 110°C | None | None | None | Present | Present |
| 135°C | 50°C | None | None | None | None | Present |
| 135°C | 70°C | None | None | None | Slight | Present |
| 135°C | 90°C | None | None | Slight | Present | Present |

According to TABLE 1, the wrinkles that occur in the photosensitive member and the uneven developing and transfer scratches caused by these wrinkles can be eliminated by applying a constant tension to the photosensitive member, and more specifically it was confirmed that applying a tension that would regulate the amount of thermal shrinkage to less than 1% was effective. More desirably, a tension should be applied that regulates thermal shrinkage to less than 1% and keeps it equal in both the lengthwise (transport direction) and widthwise directions.

According to TABLE 2, wrinkles that occur in the photosensitive member can be minimized by performing pressure transfer before cooling after heat developing has proceeded very far, or more specifically, the condition

$T/t > 10°C/s$

should be satisfied, where T is the temperature difference between the heat developing temperature and the pressure transfer temperature and t is the transport time from the heat developing section to the pressure transfer section. The reason for this is that the photosensitive member stretches when re-heated if cooling after heat developing proceeds too far and the temperature drops below the pressure transfer temperature.

The invention is intended to solve the above problems and its purpose is to offer an image forming device and a transport method for its photosensitive member that prevent the formation of wrinkles in the photosensitive member in the transport path.

This object is achieved with an image forming device and a transport method, respectively, as claimed.

In one embodiment of the invention, in order to prevent wrinkles from being formed in the photosensitive member and to improve the quality of the output image, a tensioning means is disposed in the transport path of the photosensitive member upstream of the heat developing section. The tensioning means may either be disposed between the exposure section and the heat developing section or between the supply section and the exposure section, the latter possibility assisting to achieve a good exposure and, thus, further improving the quality of the output image. The tensioning means may also be disposed in the supply section. In this case, it is advantageous to have the exposure section, the heat developing section

4

and the pressure transfer section disposed inside a main unit and the supply section adapted to be freely attached to or detached from the main unit. In such a case it is extremely easy to adjust the tension applied to the photosensitive member.

Specific embodiments of such tensioning means, by which tension can be reliably applied, are subject matter of claims 5 to 7.

By providing a tensioning means that applies tension to the photosensitive member while it is transported, it is possible to apply tension to the photosensitive member in addition to the transport force. Thermal stretching or thermal shrinkage is generated in the photosensitive member passing through the heat developing section as a result of heating. The stretching force or shrinking force due to thermal stretching or thermal shrinkage acts in all directions in minute parts of the photosensitive member, but as change in the shape of the photosensitive member, it appears as elongation or shortening in the lengthwise direction (transport direction) or widthwise direction. Of this change, elongation or shortening in the lengthwise direction is absorbed by minute changes in the transport speed, but elongation or shortening in the widthwise direction causes wrinkles. That is, elongation or shortening in minute parts of the photosensitive member appear as changes in shape on both sides of the photosensitive member. This means that even though stress may act uniformly in each part of the photosensitive member, shape changes in the middle and on the sides will differ. Therefore, as long as no shape changes occur in the photosensitive member after heating, the balance in residual stress will be lost and wrinkles will not be eliminated. On the other hand, though the width of the photosensitive member after heating is different from that before heating due to the change in shape, the transitional part from before to after heating becomes a trapezoidal shape since the photosensitive member is continuously transported. That is, the side edges of the photosensitive member from before to after heating become slanted, thus resulting in an overall funnel shape or reverse funnel shape. Tension is applied to this part in the lengthwise direction by the tensioning means. This tension generates a component force of the cosine of the angle of the slant of the slanted side parts. This component force acts in the direction opposite to that of the stretching force or the shrinking force. Therefore, this component force works to cancel out the wrinkle-forming stretching force or shrinking force. Further, by providing a tensioning means between the supply section and the exposure section, the tension can also be made to act on the photosensitive member positioned in the exposure section, thus preventing lifting or meandering and facilitating accurate exposure on the photosensitive member.

In the embodiment according to claim 8, a specific heating member is employed in the heat developing section, said heating member having a curved friction surface which is in direct contact with the rear side of the photosensitive member and regulates stretching or shrinkage of the photosensitive member by means of the friction between its friction surface and the photosensitive member.

Specific embodiments of such heating member that allow wrinkles in the photosensitive member to be reliably prevented are subject matter of claims 9 to 11.

By providing the heating member of the heat developing section with a curved friction surface that regulates stretching and shrinkage of the photosensitive member by means of frictional force, the direction of transport of the photosensitive member can be changed and stretching or shrinkage can be regulated over a larger contact area. In this case, by further providing a guide member in the exposure section or between the exposure section and the heat developing section that regulates stretching and shrinkage of the photo sensitive member, the effect of wrinkles generated in the heat developing section can be eliminated in the exposure section.

The embodiments according to claims 12 to 16 are advantageous for eliminating the effect of small wrinkles in the photosensitive member on the exposure. Such small wrinkles do not harmfully affect developing and pressure transfer but might cause an uneven exposure. Thus, by these embodiments the quality of the output image is further improved.

By returning the photosensitive member to near the downstream end of the guide member, waste of photosensitive member is avoided, and even if wrinkles should occur in the boundary part of the photosensitive member, the effect of wrinkles on the photosensitive member positioned in the exposure section is eliminated by the guide member.

As claimed in claims 17 and 19, it is desirable that the photosensitive member as it faces the heat developing section is subjected to a tension such that the thermal shrinkage in the lengthwise direction is less than 1%, in order to avoid wrinkles in the photosensitive member that could cause an uneven developing or improper image transfer. In this case, as claimed in claims 18 and 20, it is further desirable to apply a tension such that the thermal shrinkage in the lengthwise direction and that in the widthwise direction are substantially equal.

By keeping the amount of thermal shrinkage in the lengthwise direction of the photosensitive member to less than 1% by means of the tensioning means as in the embodiment of claims 17 and 19, a wrinkle prevention effect can be achieved that is sufficient to yield the above-mentioned experimental results.

In the embodiments of claims 21 and 22, the drop in temperature of the photosensitive member on its way from the heat developing section to the pressure transfer section is adjusted by the transport time. This allows to have the photosensitive member at the desired transfer temperature without re-heating. This not only obviates the need of a heating device for the pressure transfer section, but also avoids the occurrence of wrinkles that re-heating might cause.

By configuring the device such that the transport speed of the photosensitive member from the heat developing section to the pressure transfer section is $T/t > 10°C/s$, pressure transfer can be performed before cooling of the photosensitive member after heat developing proceeds too far, thus yielding the above-mentioned experimental results.

Embodiments of the invention will be explained in more detail below with reference to the drawings in which:

Fig. 1      is a cutaway view of a color copier embodying the invention;

Fig. 2      is a perspective view of a first example showing the vicinity of the supply roller of the supply section;

Fig. 3      is a perspective view of a second example showing the vicinity of the supply roller of the supply section;

Fig. 4      is a perspective view of a third example showing the vicinity of the supply roller of the supply section;

Fig. 5      is a perspective view of a fourth example showing the vicinity of the supply roller of the supply section;

Fig. 6      is an explanatory diagram of the prevention of wrinkles in the photosensitive member;

Fig. 7      is a perspective view of a fifth example showing the vicinity of the heating roller of the heat developing section;

Fig. 8      is a perspective view of a sixth example showing the vicinity of the heating roller of the heat developing section;

Fig. 9      is a perspective view of a seventh example showing the vicinity of the heating roller of the heat developing section;

Fig. 10      is a perspective view of an eighth example showing the vicinity of the heating roller of the heat developing section;

Fig. 11      is an explanatory diagram showing the re-wound condition of the photosensitive member based on the eighth example;

Fig. 12      is a perspective view of a ninth example showing the vicinity of the heat developing section and the exposure section; and

Fig. 13      is a cutaway view-of another embodiment of a color copier embodying the invention.

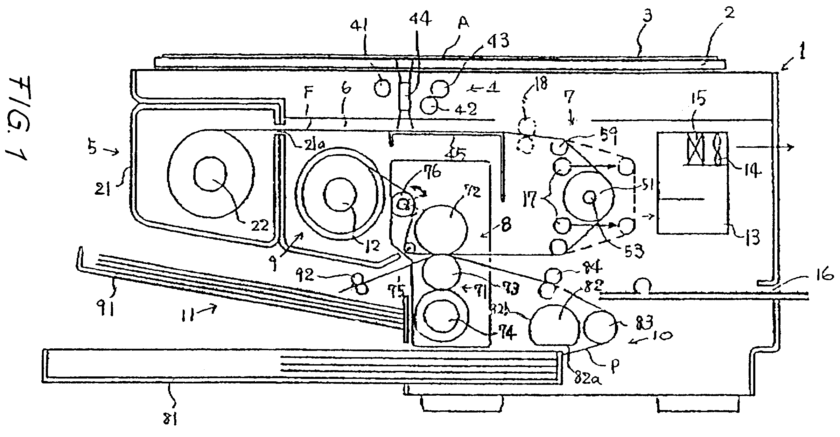

Fig. 1 is a cutaway side view of a color copier employing an embodiment of the invention. As shown in the Figure, the top surface of a copier main unit 1 is a glass original table 2, and above that an original table cover 3 is attached in such a way that it can moved between a closed position as shown and an upright opened position. An original A used as the input image is set on the original table 2, and it is copied while being held down by the original table cover 3.

An exposure section 4 is positioned inside the main unit 1 below the original table 2, and a supply section 5, which supplies the photosensitive member F, is positioned upstream from the exposure section 4. The supply section 5 is a magazine type unit that houses the photosensitive member F, and it is configured such that it can be freely attached to and detached from the main unit 1. The photosensitive member F supplied from the supply section 5 to the main unit 1 is transported along a transport path 6 as required and sequentially faces the exposure section 4, a heat developing section 7,a pressure transfer section 8 and a photosensitive member collection section 9. The transport path 6 turns back in the heat developing section 7, and each section is efficiently positioned in the main unit 1 to keep the main unit compact.

A latent image is formed on the photosensitive member F, which is transported from the supply section 5 along the transport path 6, by exposure to the input image in the exposure section 4, after which the latent image is heat developed by heating it to approximately 150°C in the heat developing section 7. The photosensitive member F, which has undergone developing, is then aligned with a paper P as the transfer member, in the pressure transfer section 8, and the developed image is pressure transferred to the paper P. Finally, the photosensitive member F and paper P are separated and the photosensitive member F is collected by rolling it up in the photosensitive member collection section 9. The paper P is supplied to the pressure transfer section 8 from a paper supply section 10 at the bottom of the main unit 1, and paper P onto which the output image has been transferred is discharged to the paper outlet section 11.

The photosensitive member F is comprised of a polyethylene terephthalate (PET) film as a base material and microcapsules charged with a coloring material and a photosensitive substance, which is made up of a photosensitive silver halide, a reducing agent and a polymer compound, and applied to the surface of the base material. The photosensitive substance performs a trigger-like function in that it undergoes a photoreaction that results in hardening of the coloring material during the development. The coloring material is provided in the colors yellow, magenta and cyan, and microcapsules of these three colors in which these coloring materials are charged are abundantly applied to the surface of the PET in a mixed condition.

In the image forming process in this embodiment the photosensitive material F undergoes a photoreaction in the exposure section 4 (formation of latent image), and the resulting change of state affects the coloring material when heated in the heat developing section 7 so that it is selectively hardened (developing). The microcapsules are crushed in the pressure transfer section 8, whereby the coloring material that has not hardened is transferred to the paper P to form the output image.

PET films tend to shrink when heated, and this shrinkage is the principal cause of residual distortion occurring in the production process. Annealing is performed to relax and adjust this distortion. In this embodiment, a photosensitive material is used that has been annealed, whose thickness is 25 $\mu$m, which is the most common thickness of products on the market, and that shrinks 0.5% at 150°C.

The left side of the main unit 1 shown in Fig. 1 is the supply section 5. It comprises a black box magazine 21 which can be attached to or detached from the main unit 1 by suitable means not shown. By means of this attachment and detachment, unexposed photosensitive member F can be mounted and exposed photosensitive member F can be re-wound into the magazine 21 and disposed off. The photosensitive member F is formed as one long piece and is rolled up on the supply roller 22 housed in the magazine 21. The photosensitive member F is continuously unrolled from the supply roller 22 with its photosensitive side facing upward and supplied through a slit 21a in the magazine 21 to the exposure section 4 located downstream.

The exposure section 4 comprises R, G and B lamps i.e., a red lamp 41, a green lamp 42 and a blue lamp 43, as light sources, a converging lens 44 and an exposure table 45, and the photosensitive member F travels on top of the exposure table 45. The red lamp 41, green lamp 42 and blue lamp 43 irradiate light toward the original on the original table 2 by means of a reflector (not shown), and the light reflected by the original A is projected on the photosensitive surface of the photosensitive member F by the converging lens 44 and a shutter (not shown), whereby exposure of the photosensitive member F is performed. In this case, the original A moves forward and backward together with the original table 2, and the photosensitive member F is transported at the same speed, thus implementing a so-called "scan exposure system".

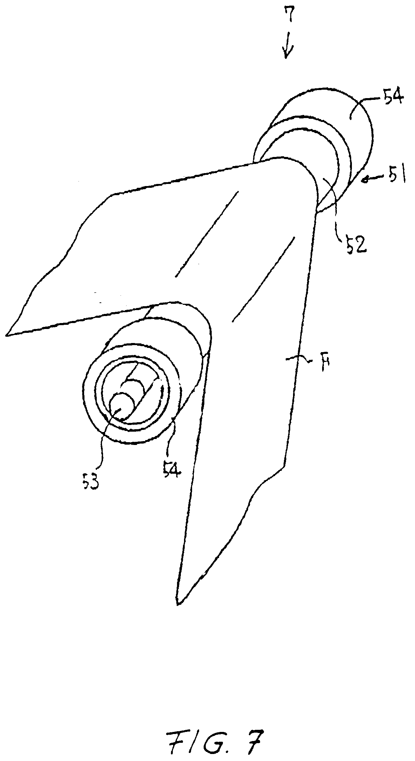

The heat developing section 7 is provided with a heating roller means 51, which serves as the heating member, and comprises a main roller unit 52 (Fig. 7) supported on a frame (not shown) of the main unit 1 so that it can rotate freely, and a halogen lamp heater 53 mounted inside the main roller unit 52. The surface temperature of the main roller unit 52 is controlled by switching this halogen lamp heater 53 on and off so that the temperature is 150 ± 3°C (155°C in some cases), and the rear surface of the photosensitive member F comes into direct contact with the surface of the main roller unit 52. The photosensitive member F is wound around the main roller unit 52 at a prescribed angle, it is heated at a prescribed developing temperature for a prescribed time period, and then it makes a U turn back toward the pressure transfer section 8. In this case, instead of a halogen lamp heater, an infrared heater, a rod-shaped ceramic heater, a sheet-shaped heating element, an electrode induction heating, electromagnetic wave heating or other type heating can be employed.

The pressure transfer section 8 comprises a transfer roller means 71, which is made up of a top roller 72, a middle roller 73 and a bottom roller 74, to which are added a separation roller 75 and a pinch roller 76. The photosensitive member F and the paper P are inserted together between the top and middle rollers 72 and 73, and here the image on the developed photosensitive member F is transferred to the paper P. In this case, it is desirable that the transfer temperature be 70 ± 3°C, and as described below, the speed at which the photosensitive member F heated in the heat developing section 7 is transported is controlled so that it has cooled to this temperature by the time it reaches this section. The top roller 72 and middle roller 73 are made from metal or another hard material, and using the top roller 72 as the drive roller, transfer is performed by forcefully pressing the photosensitive member F and paper P between both rollers 72 and 73. As explained before this transfer is performed by crushing the microcapsules on the photosensitive member F, and therefore it is necessary to apply a strong, uniform pressure to the photosensitive member F and

EP 0 485 809 A1

paper P. Here, the bottom roller 74 is in contact with the middle roller 73 so that a uniform pressure can be applied to the middle roller 73. Further, when transfer is not being performed, the middle and bottom rollers 73 and 74 move down to terminate the transfer condition. The separation roller 75 is positioned near the downstream side of the transfer roller means 71, and here the photosensitive member F and paper P are forcefully separated by bending the transport path of the photosensitive member F sharply to the inside. When the photosensitive member F is transported, the pinch roller 76 is moved to the position indicated by the dotted lines in the Figure so as to sandwich the photosensitive member F between it and the top roller 72 and apply a transport force to the photosensitive member F. That is, the pinch roller 76 is a free roller, and when it falls against the top roller 72, which is the drive roller, the photosensitive member F receives the transport force. The separated photosensitive member F is carried to the photosensitive member collection section 9 by the pinch roller 76. Desirable relationships of the transfer pressure to the transfer temperature are as follows: 100 N/mm$^2$ (1000 kg/cm$^2$) at 20°C, 40 N/mm$^2$ (400 kg/cm$^2$) at 50°C, 20 N/mm$^2$ (200 kg/cm$^2$) at 70°C and 10 N/mm$^2$ (100 kg/cm$^2$) at 90°C.

The photosensitive member collection section 9 has a take-up roller 12 on which used photosensitive member F is rolled up in a roll. When all of the photosensitive member F has been rolled up on the take-up roller 12, a clutch is disengaged to allow take-up roller 12 to rotate freely. In this condition, the supply roller 22 of the supply section 5 is driven in the opposite direction, and ultimately the used photosensitive member F is recollected in the magazine 21.

The paper supply section 10 comprises a paper cassette 81, which supplies the paper P as cut sheet paper, a half-moon roller 82, which feeds out the paper from the paper cassette 81 one sheet at a time, a guide roller 83, which changes the path that the paper P follows, and a paper supply roller means 84, which guides the paper P that has been fed out to the pressure transfer section 8. The paper cassette 81 is configured such that it can be freely attached to and detached from the main unit 1, and multiple cassettes are provided to accommodate various sizes of paper. The half-moon roller 82 has a rubber surface around its perimeter which comprises a straight part 82a and a curved part 82b. The transition part between the straight part 82a and the curved part 82b catches the leading edge of the paper P, and the following curved part 82b feeds the paper P until its leading edge reaches the paper supply roller means 84. Supply of the paper P is initiated in synchronism with the transport of the photosensitive member F so that the paper P is aligned with the exposed part of the photosensitive member F.

The paper outlet section 11 comprises an ejected paper cassette 91, which holds the paper P to which an image has been transferred, and a paper eject roller means 92, which guides the paper P from the transfer section 8 to this paper cassette 91. The paper eject roller means 92 is configured such that it tends to feed slightly more than the paper supply roller means 84, and the resulting slip rotation feeds out the paper P while also applying tension to the paper P so that it will not wrinkle or become jammed during pressure transfer.

In the Figure, 13 is an exhaust unit comprising a gas filter 14 built into an exhaust fan 14 , and it exhausts heat and gas generated in the main unit 1 through the gas filter 15 to the outside. Also in the Figure, 16 is a manual paper supply inlet for manually supplying paper P.

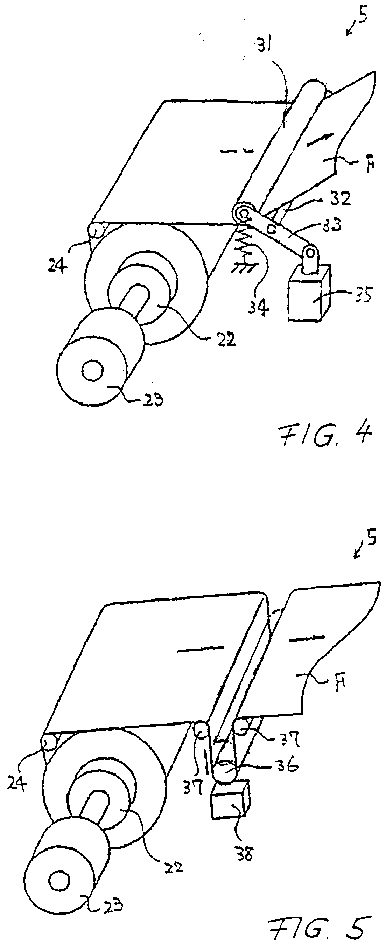

The copying process is not completed until the exposed part of the photosensitive member F reaches the pressure transfer section. There is no problem when copying is performed continuously, but in other cases, an unexposed part is sent to the pressure transfer section along with the exposed part. When the next exposure is performed in this condition, the unexposed part from the exposure section 4 to the pressure transfer section 8 is unnecessarily wasted. In this embodiment, the unexposed part is returned to near the exposure section in such cases. That is, a drive motor 23 (see Figs. 4 and 5) connected to the supply roller 22 of the supply section 5 reverses, whereby the photosensitive member F is re-wound until the boundary between the exposed part and the unexposed part reaches the vicinity of the exposure section 4.

Since in this way the unexposed part of the photosensitive member F is not wasted, it is necessary that this part is not developed in the heat developing section 7 when the unexposed part is fed forward or pulled back. Therefore, contact between the heating roller means 51 and the photosensitive member F is broken at this time. That is, a pair of movable idle rollers 17 is positioned upstream and downstream from the heating roller means 51, and these rollers 17 move horizontally so that they pull on the photosensitive member F on the transport path 6 in two locations. This movement changes the transport path so that the photosensitive member F is separated from the heating roller means 51. Therefore, when exposure is not performed continuously, the idle rollers 17 are driven at the point when the exposed part passes by the heating roller means 51 and separate the photosensitive member F from the heating roller means 51, and this separated condition is maintained until rewinding is completed when the photosensitive member F is then re-wound.

8

In addition to the above configuration, this embodiment also has several mechanisms to prevent wrinkles from being formed in the photosensitive member F. These wrinkles are generally caused by heating in the heat developing section 7, and the mechanisms used to prevent them apply tension to the photosensitive member F in the lengthwise direction (direction of transport) and the widthwise direction. Tension can be applied in the lengthwise direction by either regulating the transport of the photosensitive member F or applying tension directly, and tension can be applied in the widthwise direction by bringing an arc-shaped member in contact with the photosensitive member F and causing the frictional force in the widthwise direction to act on the photosensitive member F. This is explained in order below.

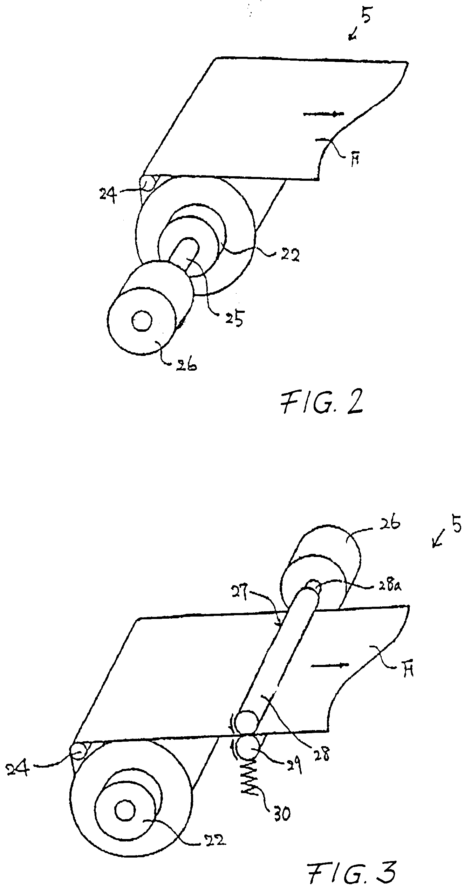

Fig. 2 is a perspective view of a first example showing the vicinity of the supply roller of the supply section 5. As shown in the Figure, the photosensitive member F is rolled up on the supply roller 22, and the photosensitive member F is fed out in a horizontal direction by a guide roller 24. A torque limiter 26 is attached to the rotational axis 25 of the supply roller 22 as a tensioning means, and it damps the transport of the photosensitive member F by restricting the rotational torque of the supply roller 22. The torque limiter 26 can be a friction clutch, a magnetic particle clutch or an electromagnetic clutch. In this case, the torque limiter is adjusted in advance so that the desired tension acts on the photosensitive member F. By this means, the photosensitive member F is damped and it is continuously fed out with the desired tension acting on it. This tension acts on the heating roller means 51 of the heat developing section 7, and as described below, in addition to its direct action to prevent wrinkles, it also acts indirectly to prevent wrinkles by increasing the frictional force of the heating roller means 51. In this way, the tensioning means is configured extremely simply in this embodiment.

Fig. 3 is a perspective view of a second example showing the vicinity of the supply roller of the supply section 5. As shown in the Figure, a feed roller means 27 is disposed downstream from the supply roller 22. This feed roller means comprises a friction roller 28, which applies frictional force to the photosensitive member F for damping, and a load roller 29, which applies a feed load to the friction roller 28, and the photosensitive member F is sandwiched between the two rollers 28 and 29. A torque limiter 26, like that above, is attached to the rotational axis 28a of the friction roller 28, and a spring 30 is attached to the load roller 29 and pushes it against the friction roller 28. Therefore, the dynamic frictional force of the friction roller 28 continually acts on the photosensitive member F being transported, whereby tension is applied by means of damping. In this case, the torque limiter 26 can be eliminated and damping achieved by the feed force and rotational friction of the rollers 28 and 20 acting on the photosensitive member F.

Fig. 4 is a perspective view of a third example showing the vicinity of the supply roller of the supply section 5. As shown in the Figure, a loading roller 31 is provided downstream from the supply roller 22, and applies tension to the photosensitive member F by pushing the photosensitive member F down. That is, the loading roller 31 is supported on one end of a rocker arm 33, which is supported by a rocker shaft 32, so that it can rotate freely, and the load roller is pulled down by a tension spring 34. A position sensor 35 is attached to the other end of the rocker arm 33, and this position sensor 35 detects the force of the tension spring 34 as the position of the loading roller 31. The drive motor 23 is attached to the rotational axis 25 of the supply roller 22, and the rotation of the drive motor 23 is controlled by a controller (not shown) so that the detected value of the position sensor remains constant. In this manner, the loading roller 31, tension spring 34, position sensor 35 and drive motor 23 make up the tensioning means so that a suitable tension is applied to the photosensitive member F. In this case, a constant tension on the photosensitive member F can be maintained regardless of the diameter of the rolled up photosensitive member F.

Fig. 5 is a perspective view of a fourth example showing the vicinity of the supply roller of the supply section 5. In this example, an idle roller 36 is provided downstream from the supply roller 22 as in the third example, but this roller 36 simply rides on top of the photosensitive member F and applies tension to the photosensitive member F by its own weight. A pair of support rollers 37 and 37 is provided underneath the photosensitive member F before and after the roller 36 in order to support it indirectly. Further, a position sensor 38 is located near the end of the roller 36, and changes in the tension due to the roller 36 are detected by this position sensor 38. As in the third example, the drive motor 23 is attached to the rotational axis 25 of the supply roller 22, and the rotation of the drive motor 23 is controlled by a controller (not shown) so that the detected value of the position sensor 38 remains constant. In this way, the roller 36, support rollers 37, position sensor 38 and drive motor 23 make up the tensioning means. In this case, tension is applied by the weight of the roller 36, and therefore a uniform tension acts on the photosensitive member F.

As described above, by configuring a suitable tensioning means as shown in the above four examples so that a fixed tension is continuously applied to the photosensitive member F being transported, wrinkles in the photosensitive member F generated in the heat developing section 7 can be prevented.

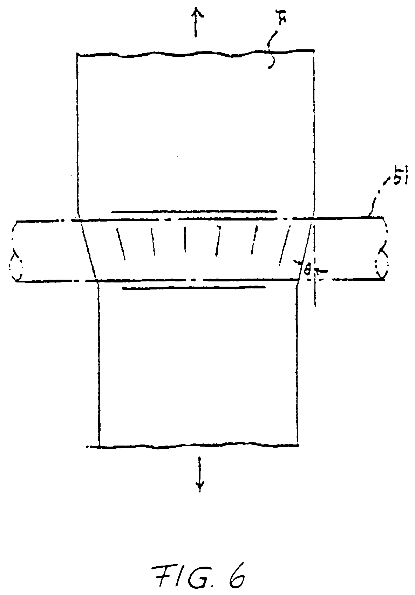

Fig. 6 is a diagram which explains the principle by which wrinkles in the photosensitive member are avoided. The PET film, which serves as the base material of the photosensitive member F, tends to shrink when heated, and as shown in the Figure, it shrinks when its temperature rises as it comes into contact with the heating roller means 51. Of this shrinkage, that in the lengthwise direction (transport direction) is absorbed by minute changes in the transport speed, but that in the widthwise direction appears as a change in the shape of the photosensitive member F, and this is the cause of so-called wrinkles. This change in shape appears as a trapezoidal shape centered on the contact of the photosensitive member F with the heating roller means 51. When tension is applied to the photosensitive member F here, a component force equivalent to $\cos\theta$ of the tension is generated, where $\theta$ is the angle formed by edges of the trapezoidal shape with the edges of the other parts. This component force acts on the shrinking trapezoidal shape, and it acts in a direction that stretches the photosensitive member F so as to cancel out the shrinkage force. Therefore, the shrinkage force is compensated for, which in turn suppresses the generation of wrinkles.

The tension required in this case is shown in TABLE 1, and the results show that a tension should be applied that keeps shrinkage to less than 1% in the lengthwise direction. As shown in the first to the fourth examples, the tension of the tensioning means is adjusted to keep shrinkage in the lengthwise direction of the photosensitive member F to less than 1% and more desirably to keep both shrinkage in the lengthwise direction and shrinkage in the widthwise direction at substantially the same value of 0.5%, or more specifically to 6 N (600 gf). This tension of approximately 6 N (600 gf) is applied to the photosensitive member F in the first and second examples by adjusting the load of the torque limiters 26 and in the third and fourth examples by adjusting the detection reference position of the position sensors 35 and 38, respectively.

In these examples, the tensioning means is positioned in the supply section 5. By positioning the tensioning means in the supply section 5, it can be freely attached to and detached from the main unit 1, thus simplifying maintenance and tension adjustment. The tensioning means could, of course, be mounted between the supply section 5 and the exposure section 4, or between the exposure section 4 and the heat developing section 7 (excluding the first example). By mounting the tensioning means between the supply section 5 and the exposure section 4, the tension also acts on the photosensitive member F positioned in the exposure section 4, thus making it possible to prevent lifting or meandering of this part and facilitating accurate exposure. By positioning the tensioning means between the exposure section 4 and the heat developing section 7, on the other hand, it is not necessary to consider the weight of the photosensitive member F in the application of the tension, thus making it possible to apply a stable, consistent tension. Moreover, by also mounting a feed roller in this part (positioned upstream from the tensioning means), the exposure speed of the scan type exposure can be stabilized in addition to preventing wrinkles.

Next is an explanation of a fifth example that causes frictional force to act on the photosensitive member F. Fig. 7 is a perspective view of this embodiment showing the vicinity of the heating roller means 51 in the heat developing section. As shown in the Figure, the heating roller means 51 comprises the cylindrical roller unit 52 in which the halogen lamp heater 53 is inserted, and it is attached to the frame (not shown) of the main unit 1 via a pair of bearings 54 and 54 on the ends of the roller unit 52. The roller unit 52 makes up the curved friction surface of the heating roller means 51, and it comes into direct contact with the rear surface of the photosensitive member F on its peripheral surface. The roller unit 52 is made from aluminum or an aluminum alloy with good heat conductance so that it warms up smoothly, and the surface is polished so that sufficient frictional force can be achieved with respect to the film type photosensitive member F. By means of this configuration, shrinkage of the photosensitive member F, particularly that in the widthwise direction, due to heating by the heating roller means 51 and the subsequent cooling is inhibited by the static frictional force between the photosensitive member and the roller unit 52.

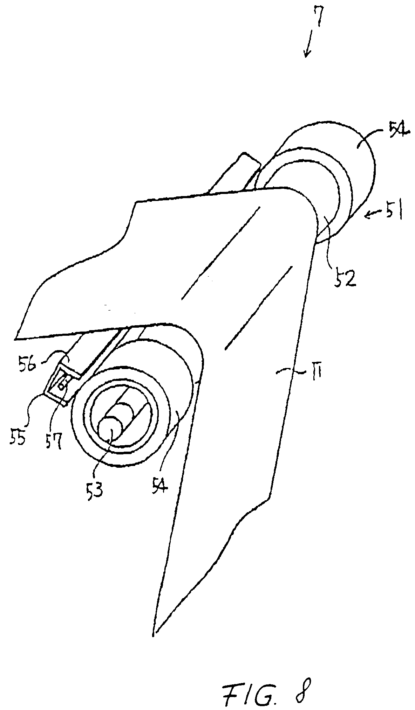

Fig. 8 is a perspective view of a sixth example showing the vicinity of the heating roller means 51 in the heat developing section. This example employs a structure that causes a electrostatic force to act on the photosensitive member F in addition to the frictional force. As shown in the Figure, the heating roller means 51 is also provided with a charging unit 55, which charges the roller unit 52 of the heating roller means 51 by corona discharge. The charging unit 55 has a straight discharge wire 57 inside a case 56 and it causes a electrostatic force to act on the photosensitive member F via the charged roller unit 52, thereby causing so-called "static cling" of the photosensitive member F. Therefore, frictional force and electrostatic force act on the photosensitive member F in the widthwise direction at the same time and inhibit shrinkage of the photosensitive member, i.e., the generation of wrinkles. The discharge wire 57 can be a gold, platinum or carbon-coated tungsten wire.

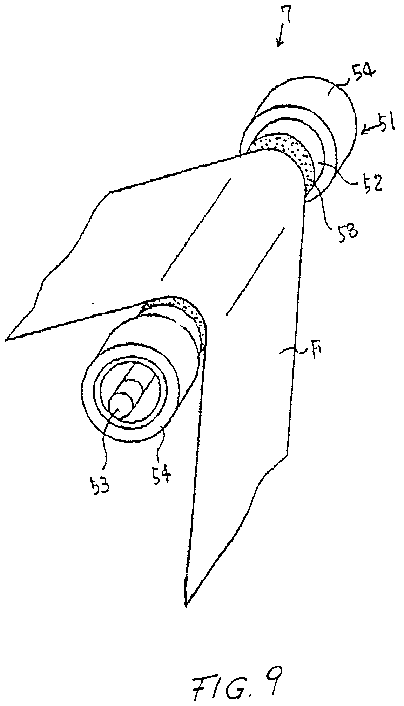

Fig. 9 is a perspective view of a seventh example showing the vicinity of the heating roller means 51 in the heat developing section. In this example, the roller unit 52 of the fifth example is covered with a heat-resistant rubber 58 or other material. It is desirable that the heat-resistant rubber be a silicon rubber, and it should be as thin as possible in consideration of heat conductance. In the fifth, sixth and seventh examples, a roller unit 52 that was 30 mm in diameter was used, but its diameter can be 20 to 100 mm, or more desirably 25 to 50 mm. As shown in the fifth to the seventh examples above, the shrinkage force generated in the photosensitive member F is cancelled out to prevent wrinkles in the photosensitive member F by applying a frictional force to the photosensitive member F via the heating roller means 51. Of course, in this case, as long as wrinkles are prevented to the extent they do not affect pressure transfer, i.e., within a range that does not degrade the quality of the output image, the purpose is achieved. However, even wrinkles that do not affect pressure transfer may cause the photosensitive member to lift when transmitted from the heat developing section 7 to the exposure section 4, resulting in a poor latent image. For this reason, it is necessary to eliminate the effect of such wrinkles on the exposure section 4, which is explained in the embodiment below.

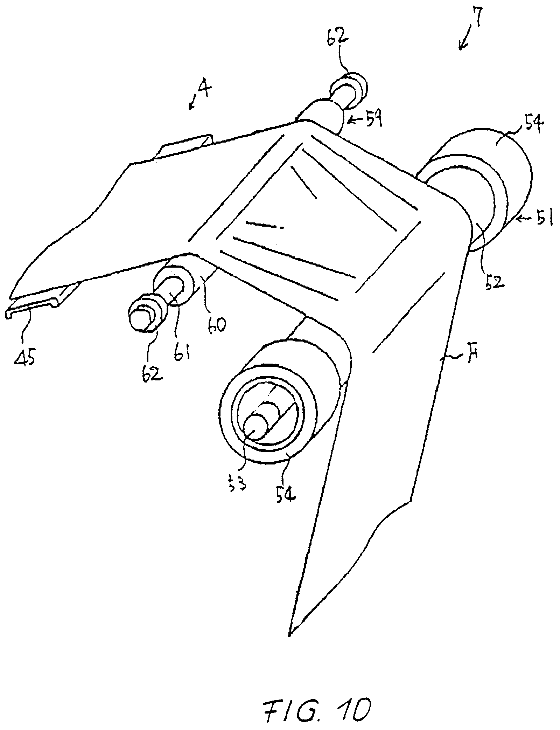

Fig. 10 is a perspective view of an eighth example showing the vicinity of the heating roller means 51 in the heat developing section. In this example, a guide roller means 59, which serves as a guide member, is mounted upstream from the heating roller means 51. The guide roller means 59 comprises the freely rotating roller unit 60 on a support shaft 61, and it is attached to the frame (not shown) of the main unit 1 via a pair of left and right bearings 62 and 62 on either end of the support shaft 61. The roller unit 60 is made from natural rubber, nitrile rubber, silicon rubber or other rubber material, and its peripheral surface comes into contact with the photosensitive member F, thus causing frictional force (static friction coefficient: 0.5 or greater) to act on the photosensitive member F in the widthwise direction. In this case, the transmission of wrinkles generated by the heating roller means 51 is stopped by this guide roller means 59, thus preventing the wrinkles from affecting the exposure section 4. Therefore, lifting of the photosensitive member F in the exposure section 4 can be prevented and a good latent image can be obtained. By polishing the surface of the roller unit 60 to a mirror finish, frictional force can be further increased. The roller unit 60 of the guide roller means 59 in this example was 15 mm in diameter, but it can be 6 to 30 mm, or more desirably 10 to 20 mm. In addition, the angle at which the photosensitive member F is wrapped around the guide roller means 59 and the tension applied to the photosensitive member F should be greater than 15 degrees and greater than $6 \times 10^{-2}$ N (6 gf), respectively.

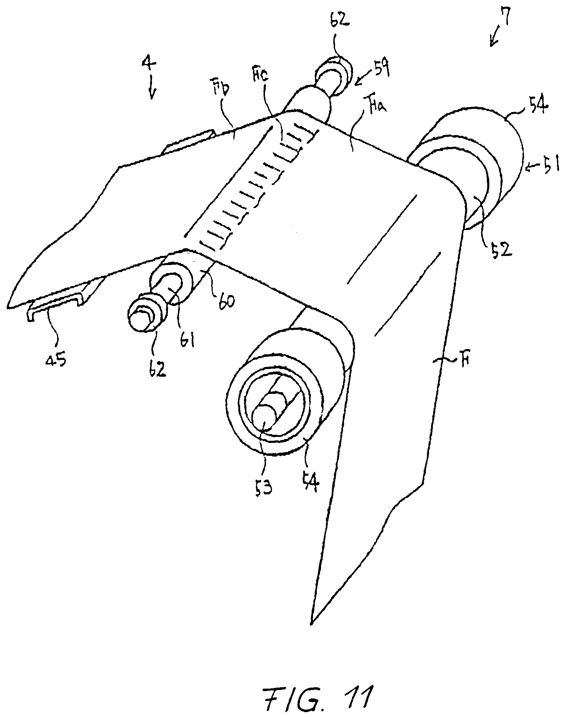

Fig. 11 is an explanatory diagram, on the basis of the eighth example, of the case in which the photosensitive member is re-wound. The moment the photosensitive member F is pulled away by the idle rollers 17 and 17, it is transported with wrinkles remaining in that part. That is, wrinkles have formed in the photosensitive member F in the boundary part Fc between the exposed part Fa and the unexposed part Fb even after transfer in the pressure transfer section is completed and the photosensitive member is pulled back. As shown in the same Figure, in this embodiment, the photosensitive member is re-wound until the boundary part is positioned on the downstream side of the guide roller means 59. The re-wound position should be 2 to 30 mm, or more desirably 10 to 20 mm, downstream from the guide roller means 59. By this means, the effect of these wrinkles is not transmitted to the exposure section 4, thereby eliminating the effect of the wrinkles on the latent image. The rewinding method employed can be that described in the ninth embodiment below.

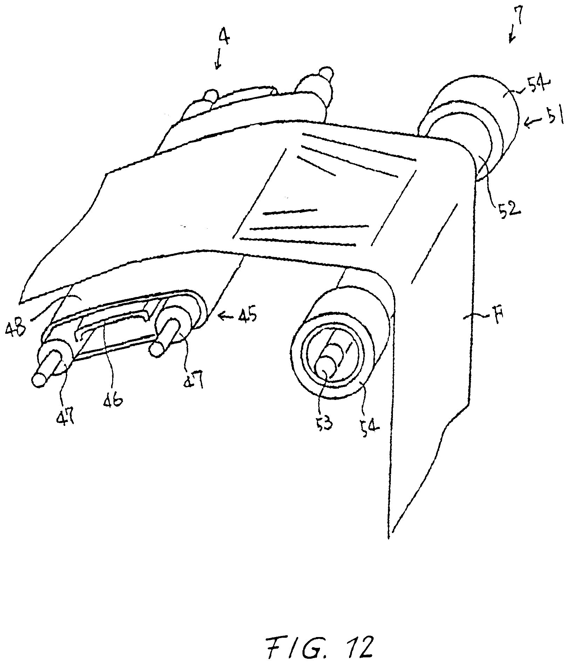

Fig. 12 is a perspective view of the ninth example showing the vicinity of the heat developing section and the exposure section. In this embodiment, the exposure table 45 of the exposure section 4 is configured like a conveyor belt and is positioned slightly higher than the heating roller means 51. This exposure table 45 comprises a plate-like table unit 46, a pair of roller-like pulleys 47 and 47 (supported on the frame) positioned before and after the table unit 46, and an endless wide belt 48 wrapped around the roller-like pulleys 47 and 47. Since the roller-like pulleys rotate freely, the wide belt 48 travels over the table unit 46 according to the travel of the photosensitive member F. The wide belt 48 is made from natural rubber, nitrile rubber, silicon rubber or other rubber material, and the rear surface of the photosensitive member F fits snugly against its surface to cause frictional force to act in the widthwise direction of the photosensitive member F. In this case, since the exposure table 45 is positioned slightly higher than the heating roller means 51, transmission of wrinkles from the heating roller means 51 is stopped at the roller-like pulley 47 on the downstream side, and wrinkles in the photosensitive member F on the exposure table 45 are inhibited by the frictional force of the exposure table 45 itself. In this embodiment, the thickness of the wide belt 48 should be greater than 0.5 mm and the tension applied to the photosensitive member F greater than $10^{-1}$ N (10 gf). The middle part of the table unit 46 can be raised slightly (radius of curvature: 50 to 500 mm) to strengthen the contact force between the wide belt 48 and the photosensitive member F and thereby to increase the frictional force.

As described above in the eighth and ninth examples, the effect of wrinkles on the exposure section 4 is eliminated by the guide roller means 59, thereby yielding a good latent image. In the above embodiments, the supply roller 22 of the supply section 5, the top roller 72 of the pressure transfer section 8 and the take-up roller 12 of the photosensitive member collection section 9 make up the drive system for the photosensitive member F, but it is also desirable to provide a feed roller means 18 downstream from the exposure section 4 as described above. In this case, the supply roller 22 rewinds the photosensitive member F, the feed roller means 18 controls the speed of the photosensitive member F in the exposure section 4, the top roller 72 transports the photosensitive member F after the feed roller means 18, and the take-up roller 12 rolls up the used photosensitive member F.

Below, the drive system, i.e., the series of actions of the transport system for the photosensitive member F, is explained together with the transport system for the paper P. The feed roller means 18 is driven when exposure starts, and the photosensitive member F is pulled out from the magazine 21. The pinch roller 76 comes into contact with the top roller 72 and drive of the top roller 72 starts slightly delayed behind the drive of the feed roller means 18. The take-up roller 12 is driven sequentially with the drive of the top roller 72. The exposed part of the photosensitive member F is transported to the pressure transfer section 8 from the exposure section 4 through the heat developing section 7 by the top roller 72. When the exposed part of the photosensitive member F is transported to near the pressure transfer section 8, the half-moon roller 82 is driven and feeds out the paper P, after which the paper supply roller means 84 is driven and aligns the paper P with the exposed part of the photosensitive member F. When transfer begins, the paper eject roller means 92 is driven and carries the separated paper P to the ejected paper cassette 91, while the photosensitive member F is rolled up on the take-up roller 12 after passing the pinch roller 76. In this case, the rollers 17 and 17 are driven when the unexposed part of the photosensitive member F reaches the heat developing section 7 and separate the photosensitive member F and the heating roller means 51, and when the photosensitive member reaches the pressure transfer section, the middle and bottom rollers 73 and 74 move down and release the transfer condition. Also, all of the rollers stop when one complete copy operation is completed. As the rollers stop, the pinch roller 76 separates from the top roller 72 (condition in Fig. 1), the bottom roller 74 moves down releasing the contact between the top roller 72 and the middle roller 73, and the movable rollers 17 are driven to release the contact between the photosensitive member F and the heating roller means 51. When rewinding is performed, the clutches of the feed roller means 18, pinch roller 76 and take-up roller 12 are disengaged to allow these rollers to turn freely, and the supply roller 22 is driven in reverse and rolls the photosensitive member F back up. Of course, the driving and stopping of each of these rollers is detected and controlled by encoders and sensors not shown in the Figures.

In order to obtain high quality output images in these embodiments, the photosensitive member F should be heated to a developing temperature of $150 \pm 3°C$ in the heat developing section 7 and to a transfer temperature of $70 \pm 3°C$ in the pressure transfer section 8. In this case, if the photosensitive member is heated to $70°C$ after it has been cooled from $150°C$ to below $70°C$, thermal stress causes thermal expansion in the photosensitive member F, resulting in transfer wrinkles. Therefore, transfer wrinkles can be prevented and the structure simplified by allowing the photosensitive member F, which has been heated to $150°C$ in the heat developing section 7, to cool naturally so that it is at $70°C$ when it reaches the pressure transfer section 8. Therefore, the transport speed of the photosensitive member F and the distance from the heat developing section 7 to the pressure transfer section 8 are set so that $T/t > 10°C/s$, where T is the difference between the developing temperature and the transfer temperature and t is the transport time from the heat developing section 7 to the pressure transfer section 8. Of course, the transport speed is determined by the top roller 72 of the pressure transfer section 8, but since there are restrictions on the exposure speed and the retention time of the developing temperature, the drop in temperature is mainly adjusted by the distance between the heating roller means 51 of the heat developing section 7 and the transfer roller means 71 of the pressure transfer section. By this means, the experimental results in TABLE 2 can be adequately satisfied while preventing transfer wrinkles.

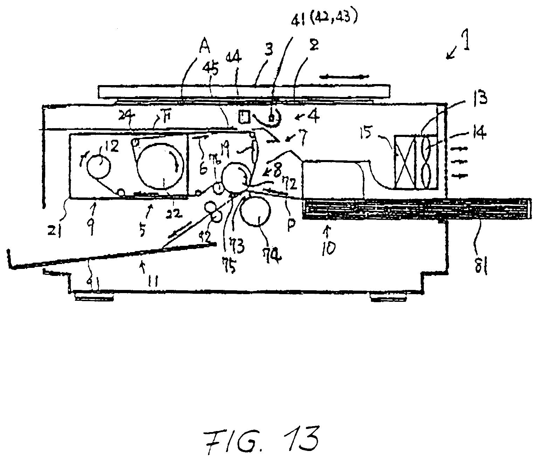

Fig. 13 is a cutaway view of another embodiment of a color copier implementing the invention. As shown in this Figure, the supply roller 22 and the take-up roller 12 are housed inside the magazine 21, and in addition to the heating roller means 51 of the heat developing section 7, there is also a heating plate 19 with a curved heating surface. This heating plate 19 is an aluminum plate with a built-in plate-like heater, and developing is performed by having the photosensitive material slide over this surface.

In the foregoing various embodiments of the invention have been described as implemented in a color copier, but the invention can be applied to printers, plotters, facsimile machines, electronic cameras and other devices as well.

**Claims**

1. An image forming device in which a film type photosensitive member (F) is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein

a tensioning means (26; 26-30; 31-35; 36-38) for applying a tension to the photosensitive member being transported is disposed in the transport path (6) upstream from the heat developing section (7) or in the supply section (5).

2. The image forming device of claim 1, wherein the tensioning means (59-62) is disposed between the exposure section (4) and the heat developing section (7).

3. The image forming device of claim 1, wherein the tensioning means is disposed between the supply section (5) and the exposure section (7).

4. The image forming device of claim 1, wherein the exposure section (4), the heat developing section (7) and the pressure transfer section (8) are disposed inside a main unit (1), while the supply section (5) is adapted to be freely attached to or detached from the main unit and the tensioning means is disposed in the supply section (5).

5. The image forming device of any of the preceding claims, wherein the tensioning means comprises

a pair of rollers (28, 29) disposed such that the photosensitive member (F) is inserted between them and

a torque limiter (26) is connected to the rollers and applies a damping torque to the rollers.

6. The image forming device of any of the preceding claims, wherein the tensioning means comprises

a drive motor (23) for supplying the photosensitive member (F),

a sensor (35; 38) for detecting the tension of the photosensitive member, and

a controller for controlling the drive motor in response to the tension detected by the sensor (35; 38).

7. The image forming device of claim 4, wherein the tensioning means comprises

a supply roller (22) on which the photosensitive member to be supplied is wound and

a torque limiter (26) for applying a damping torque to the supply roller (22).

8. An image forming device in which a film type photosensitive member (F) is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein

the heat developing section (7) is provided with a heating member (52; 19) for heating the photosensitive member (F),

said heating member having a curved friction surface directly contacting the photosensitive member from the rear for regulating stretching or shrinkage of the photosensitive member by means of the frictional force generated between said friction surface and the photosensitive member.

9. The image forming device of claim 8, wherein the heating member (52) is a metal roller whose curved friction surface has been polished.

10. The image forming device of claim 9, wherein the metal roller (52) has an electrostatic charging unit (55) associated therewith.

13

11. The image forming device of claim 8, wherein the heating member is a roller (52) made from a heat conductive material, the curved friction surface of the roller being covered with a heat resistant rubber (58).

12. The image forming device of any of claims 8 to 11, wherein the exposure section (4) is equipped with a guide member (45) in direct contact with the photosensitive member (F) for regulating stretching and shrinkage of the photosensitive member by means of the frictional force generated between it and the photosensitive member.

13. The image forming device of claim 12 wherein the guide member (45) is a belt type exposure table whose surface, at least, is made from a rubber material and which is movable together with the photosensitive member (F).

14. The image forming device of any of claims 1 to 8, wherein a guide member (60) in direct contact with the photosensitive member (F) is disposed between the exposure section (4) and the heat developing section (8) for regulating stretching or shrinkage of the photosensitive member by means of the frictional force generated between it and the photosensitive member.

15. The image forming device of claim 14 wherein the guide member (60) is a freely rotating roller whose surface, at least, is covered with a rubber material.

16. A method for transporting a photosensitive member (F) in the image forming device of claim 12 or 14, in which an unexposed part of the photosensitive member (F) that has passed the exposure section (4) is, after completion of an image forming operation, retracted back to the exposure section until the boundary part between the unexposed part and exposed part of the photosensitive member is positioned near the downstream end of the guide member (60).

17. The image forming device of any of claims 1 to 15, wherein
the photosensitive member (F) has a polyethylene terephthalate film as a base material,
the tensioning means applies tension to the photosensitive member facing the heat developing section and
the tensioning means is adapted to control the tension so that thermal shrinkage in the lengthwise direction of the photosensitive member facing the heat developing section is less than 1%.

18. The image forming device of claim 17, wherein
the tensioning means is adapted to control the tension so that thermal shrinkage in the lengthwise direction and that in the widthwise direction of the photosensitive member facing the heat developing section are substantially the same.

19. A method for transporting a photosensitive member (F) in an image forming device in which a film type photosensitive member (F) having a polyethylene terephthalate film as a base material, is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein
at least the photosensitive member facing the heat developing section (7) is transported with tension being applied so that thermal shrinkage in the lengthwise direction of the photosensitive member is less than 1%.

20. The method of claim 19, wherein
the photosensitive member (F) is transported so that thermal shrinkage in the lengthwise direction and that in the widthwise direction are substantially the same.

21. An image forming device in which a film type photosensitive member (F) having a polyethylene terephthalate film as a base material, is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein

transport means are provided for transporting the photosensitive member (F) along the transport path (6),

the transport means being configured such that at least the transport speed from the heat developing section (7) to the pressure transfer section (8) is controlled so that

$T/t > 10°C/s$

where T is the temperature difference between the temperature to which the photosensitive member is heated in the heat developing section and the temperature to which it is heated in the pressure transfer section and t is the time required to transport the photosensitive member from the heat developing section to the pressure transfer section.

22. A method for transporting a photosensitive member (F) in an image forming device in which a film type photosensitive member (F) having a polyethylene terephthalate film as a base material, is sequentially transported from a supply section (5) along a transport path (6) to an exposure section (4), a heat developing section (7) and a pressure transfer section (8), a latent image is formed on the photosensitive member by exposure to an input image in the exposure section (4), the latent image is heat developed in the heat developing section (7) and the developed image is then transferred to a transfer member (P) in the pressure transfer section (8), wherein

the photosensitive member is transported from the heat developing section (7) to the pressure transfer section (8) at a transport speed such that

$T/t > 10°C/s$

where T is the temperature difference between the temperature to which the photosensitive member is heated in the heat developing section and the temperature to which it is heated in the pressure transfer section and t is the time required to transport the photosensitive member from the heat developing section to the pressure transfer section.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 819 032 (NAGUMO)<br><br>* column 1, line 7 - line 10 *<br>* column 2, line 40 - line 47 *<br>* column 3, line 40 - line 48 *<br>* column 3, line 67 - column 4, line 10 *<br>* column 5, line 50 - column 6, line 8; figures 1,2 *<br>--- | 1,2,4,8, 13,14 | G03B27/32<br>G03F7/00 |
| A | EP-A-0 350 310 (BROTHER)<br><br>* column 1, line 7 - line 11 *<br>* column 5, line 35 - line 53 *<br>* column 7, line 16 - line 49 *<br>* column 8, line 37 - column 9, line 39; figures 1,2,4-8 *<br>--- | 5,6,14, 15 | |
| P,A | US-A-5 049 919 (SAKAKIBARA ET AL.)<br>* column 1, line 9 - line 15 *<br>* column 1, line 36 - line 60; claim 1; figure 1 *<br>--- | 16 | TECHNICAL FIELDS SEARCHED (Int. Cl.5 ) |
| A | PATENT ABSTRACTS OF JAPAN<br>vol. 14, no. 319 (M-0996)9 July 1990<br>& JP-A-02 106 396 ( SEIKO INSTR. ) 18 April 1990<br>* abstract *<br>--- | 17 | G03B<br>G03F<br>G03G |
| A | WO-A-8 304 319 (HAUS)<br>* page 1, line 3 - line 16 *<br>* page 4, paragraph 3; figure 1 *<br><br>----- | 13 | |

The present search report has been drawn up for all claims

| Place of search | Date of completion of the search | Examiner |
|---|---|---|
| THE HAGUE | 16 MARCH 1992 | GREISER N. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
........................................................................................
& : member of the same patent family, corresponding
   document

EPO FORM 1503 03.82 (P0401)